Europäisches Patentamt

(19) European Patent Office

Office européen des brevets

(11) Publication number: 0 127 238
A1

## (12) EUROPEAN PATENT APPLICATION

(21) Application number: 84200741.1

(22) Date of filing: 23.05.84

(51) Int. Cl.³: H 03 B 5/36

(30) Priority: 30.05.83 NL 8301905

(43) Date of publication of application:
05.12.84 Bulletin 84/49

(84) Designated Contracting States:
AT BE CH DE FR GB IT LI SE

(71) Applicant: N.V. Philips' Gloeilampenfabrieken
Groenewoudseweg 1
NL-5621 BA Eindhoven(NL)

(72) Inventor: Kasperkovitz, Wolfdietrich Georg
c/o INT. OCTROOIBUREAU B.V. Prof. Holstlaan 6
NL-5656 AA Eindhoven(NL)

(72) Inventor: Van Rumpt, Herman Wouter
c/o INT. OCTROOIBUREAU B.V. Prof. Holstlaan 6
NL-5656 AA Eindhoven(NL)

(74) Representative: Schoonheijm, Harry Barend et al,
INTERNATIONAAL OCTROOIBUREAU B.V.
Prof.Holstlaan 6
NL-5656 AA Eindhoven(NL)

(54) Oscillator circuit.

(57) Oscillator circuit comprising an amplifier arrangement (A, A') connected to a reference level an output and an input thereof being coupled *via* a single signal-carrying terminal (t, t') to a resonant network (Z, Y) which is connected to the same reference level as the amplifier arrangement (A, A'), the resonant network (Z, Y) comprising a crystal resonator (Q), in which oscillator circuit a stable oscillation at a higher order crystal resonant frequency is achieved by means of an LC-network (LC, L'C,') which selects said higher order crystal resonant frequency and a resistor (Rp), connected in parallel with the crystal resonator (Q), which prevents parasitic oscillations at the resonant frequency determined by the components of the LC-network (LC, L'C,') and the case or holder capacitance of the crystal resonator (Q).

FIG.1

"Oscillator circuit".

The invention relates to an oscillator circuit comprising an amplifier arrangement connected to a reference level  an output  as well as an  input thereof being coupled _via_ a single signal-carrying terminal to a resonant network which is connected to the same reference level as the amplifier arrangement, the resonant network including a crystal resonator.

Such an oscillator circuit is disclosed in Netherlands Patent Application No. 8,002,064 (PHN 9728), which has been laid open to public inspection.

The amplifier arrangement of the prior art oscillator circuit functions as a negative resistance for the resonant network and is simple to integrate. Because of the single, signal voltage-carrying connection between this integratable amplifier arrangement on the one hand and the resonant network which cannot be integrated or is difficult to integrate on the other hand, this prior art oscillator circuit is particularly suitable for use in integrated circuits whose number of pins must be kept to a minimum. In the above-mentioned construction (one-pin crystal oscillator) the crystal resonator stabilizes the oscillation frequency in the resonant network of the known oscillator circuit. Oscillation then occurs only at the first harmonic of the crystal resonantor, called first order crystal frequency hereinafter for the sake of brevity.

It is an object of the invention to effect a stable oscillation at a higher order crystal frequency in a one-pin crystal oscillator.

According to the invention, an oscillator circuit of the type defined in the opening paragraph is characterized in that the resonant network comprises a LC-network coupled to the crystal resonantor for selection of a higher order resonant frequency of the crystal resonator, and also a resistor which is arranged in parallel with the crystal resonator for preventing oscillations at the parasitic resonant frequency produced by the LC-network and the case capacitance of the crystal resonator.

Thus the amplitude of the (real in-phase signal which is positively fed back to the amplifier arrangement may be increased at the desired higher order crystal frequency relative to the amplitude of the signal at the unwanted crystal frequencies by means of the LC-network, and relative to the amplitude of the signal at the said parasitic resonant frequency by means of the said resistor. With a suitable choice of the gain, it can then be accomplished that the condition for oscillation is only satisfied at the desired higher order crystal frequency.

From United States Patent no. 4,134,085 it is known per se to shunt a crystal resonator by means of a resistor in order to suppress the parasitic parallel crystal frequency caused by the case capacitance, with respect to the first harmonic. In contrast therewith, in the oscillator circuit according to the invention said LC-member prevents the occurrence of oscillation at this parasitic crystal frequency.

A preferred embodiment of an oscillator circuit according to the invention, is characterized in that the amplifier arrangement has a current output which is coupled to the terminal, and the resonant network comprises two branches arranged in parallel between the terminal and the reference level, one branch comprising a series arrangement of one of the two components of the LC-network and the parallel arrangement of the crystal resonator and the said resistor and the other branch comprising the other component of the LC-network, the real part of the impedance of the resonant network between the terminal and the reference level at the parasitic resonant frequency being smaller than the real impedance of said network at the said higher order resonant frequency of the crystal resonator.

When this measure is used, the output current of the amplifier arrangement produces across the resonant network a voltage whose amplitude is at a maximum at the selected higher order crystal frequency and which is positively fed back to an input of the amplifier arrangement <u>via</u>
the terminal.

This preferred embodiment is preferably further
characterized in that in the said one branch the capacitance
of the LC-network is arranged in series with the parallel arrangement of the crystal resonator and the said resistor and that the inductance of the LC-network is included in the said other branch.

When this measure is applied a simple d.c. setting of the amplifier arrangement is possible.

As an alternative an embodiment of an oscillator circuit according to the invention may be characterized in that the amplifier arrangement has a voltage output which is coupled to the terminal and the LC-network is a series LC-network arranged between the terminal and the reference level in series with the parallel arrangement of the crystal resonator and the said resistor, the real part of the impedance of the resonant network between the terminal and the reference level at the parasitic resonant frequency being larger than the real impedance of said network at the said higher order resonant frequency of the crystal resonator.

When this measure is applied, the output voltage of the amplifier arrangement produces a current through the resonant network, whose amplitude is at its maximum at a selected higher order crystal frequency and which is positively fed back to an input of the amplifier arrangement _via_ the terminal.

The invention will be further explained with reference to the Figures in the accompanying drawings, which Figures serve as examples and in which corresponding elements have been given the same reference numerals.

Therein:

Figure 1 shows an oscillator circuit according to the invention;

Figure 2 shows an equivalent circuit diagram of the resonant network of the oscillator circuit of Figure 1;

Figures 3A, B and C show equivalent circuit diagrams of the resonant network of the said oscillator circuit at the first and third order crystal frequencies and at the parasitic resonant frequency;

Figure 4 shows the frequency-dependent variation of the real part of the impedance of the resonant network, with the resistance arranged in parallel with the crystal resonator as a parameter;

Figure 5 shows the frequency-dependent variation of the imaginary part of the impedance of the resonant network, with the said resistance as a parameter;

Figure 6 shows as oscillator circuit according to the invention, which is the dual of the one of Figure 1.

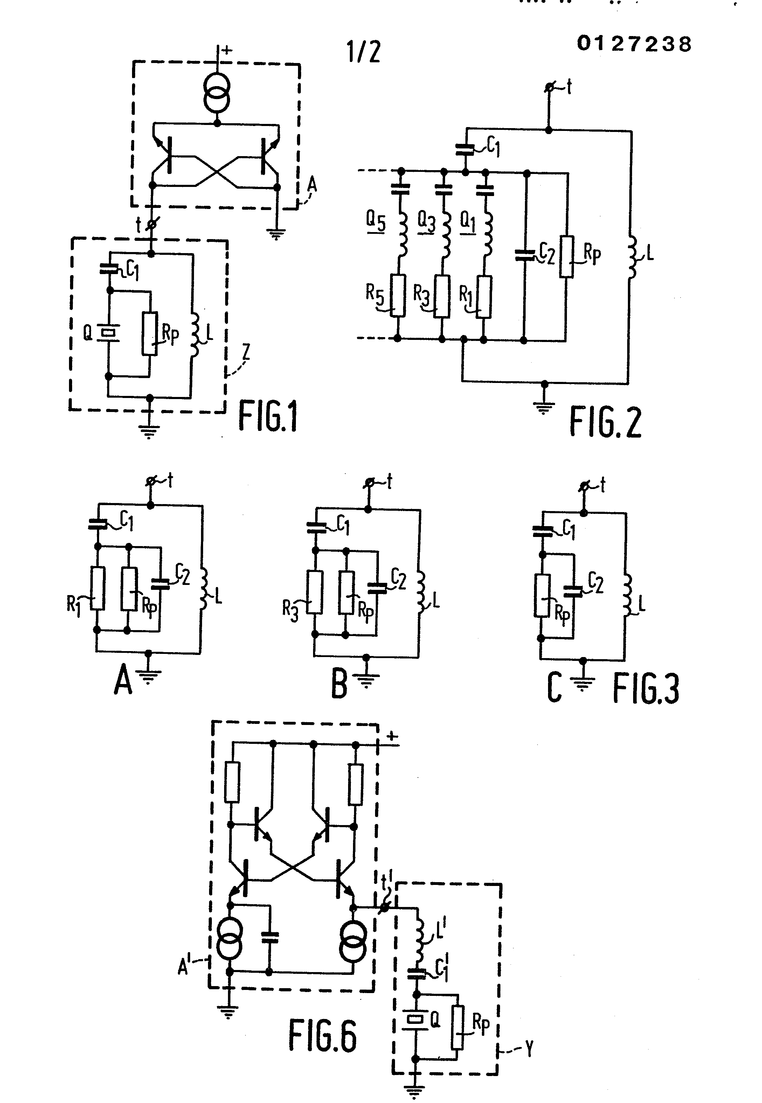

Figure 1 shows an oscillator circuit according to the invention comprising an integrated amplifier arrangement A, which is connected to a grounded resonant network Z $\underline{via}$ a signal-carrying terminal $\underline{t}$, the ground reference contact of the resonant network Z corresponding to that of the amplifier arrangement A.

The amplifier arrangement A is known $\underline{per\ se}$ and used in $\underline{inter\ alia}$ the integrated circuit TDA 7000. For an understanding of the invention it is sufficient to mention that the amplifier arrangement A is a voltage-controlled current source whose terminal $\underline{t}$ constitutes both the voltage input and the current output. The amplifier arrangement A applies to the resonant network Z $\underline{via}$ the terminal $\underline{t}$ an output current which is controlled by the voltage across this resonant network Z. Arrangement A consequently must be understood to be a negative resistance $-R$, which is arranged in parallel with the resonant network Z.

As is known, oscillation occurs at a loop gain equal to unity. In the embodiment shown this takes place when the impedance of the resonant network Z is real and at least as large as the negative resistance $/-R/$ of the amplifier arrangement A. If such a situation occurs at different frequencies, then the oscillation frequency at which said impedance is real and at its maximum will be dominant over the other frequencies.

The resonant network Z comprises a parallel LC-network $LC_1$ of which the capacitance $C_1$ is arranged in a first branch between the terminal $\underline{t}$ and ground in series with a parallel arrangement of a crystal resonator Q and a resistor $R_p$ and of which the inductance L is included

in a second branch which is arranged in parallel with the first branch.

Figure 2 shows the resonant network Z in which the crystal resonator. Q is represented by a plurality of parallel RLC series resonant networks $Q_1$, $Q_3$, $Q_5$ ........., each having a comparatively high quality factor and each being tuned to a respective one of the crystal frequencies $f_o$, $3f_o$, $5f_o$ ........., $f_o$ being the first order or fundamental crystal frequency. The case or holder capacitance of the crystal resonator Q, called crystal capacitance hereinafter, is represented by means of a capacitor $C_2$, which is connected in parallel with the RLC series resonant networks $Q_1$, $Q_3$, $Q_5$ ..........

Because of said comparatively high quality factors the crystal resonator Q can be represented, in the resonant mode, by the parallel arrangement of one of the comparatively low series resistances $R_1$, $R_3$ ......of the series resonant networks $Q_1$, $Q_3$......and the crystal capacitance $C_2$. Figures 3A and 3B show, by way of example, the equivalent circuit diagram of the resonant network Z at the first and the third order crystal frequency, respectively ($f_o$ and $3f_o$, respectively). The series resistances $R_1$ and $R_3$ are of approximately the same order of magnitude and are not only arranged in parallel with the above-mentioned crystal capacitance $C_2$ but also in parallel with the resistance $R_p$.

If oscillation is desired at, for example, the third order crystal frequency $3f_o$, then the resonant frequency of the parallel LC-network $LC_1$ must be chosen equal or at least substantially equal thereto, so that the real impedance of the resonant network Z at this desired crystal frequency $3 f_o$ is at least higher than the real part of the impedance at the other crystal frequencies $f_o$, $5f_o$, $7f_o$ ..........

However, in combination with the crystal capacitance $C_2$ the parallel LC-network $LC_1$ produces a parasitic resonant frequency ($f_{par}$), whatever the state of the crystal resonator Q. At this parasitic resonant frequency

$f_{par}$ the resonant network Z can be represented by the equivalent circuit diagram shown in Figure 3C, in which the impedance of the crystal resonator is only determined by its crystal capacitance $C_2$.

If the resistor $R_p$ were not present, that is to say if $R_p$ were to equal $\infty$ , then the losses in the resonant network Z at the crystal frequencies $f_o$, $3f_o$.... would be determined by the series resistances $R_1$, $R_3$.... respectively and there would be no losses at the parasitic resonant frequency $f_{par}$. Consequently, the impedance of the resonant network Z would be not only real but also at its maximum at the last-mentioned frequency $f_{par}$. Thus, the oscillator circuit would oscillate at this unwanted parasitic resonant frequency $f_{par}$, which is sensitive to temperature-fluctuations and ageing of the components. However in fact the impedance of the resonant network Z, particularly at the unwanted parasitic resonant frequency $f_{par}$, is reduced by means of the resistance $R_p$ relative to the impedance at the desired third order crystal frequency $3f_o$.

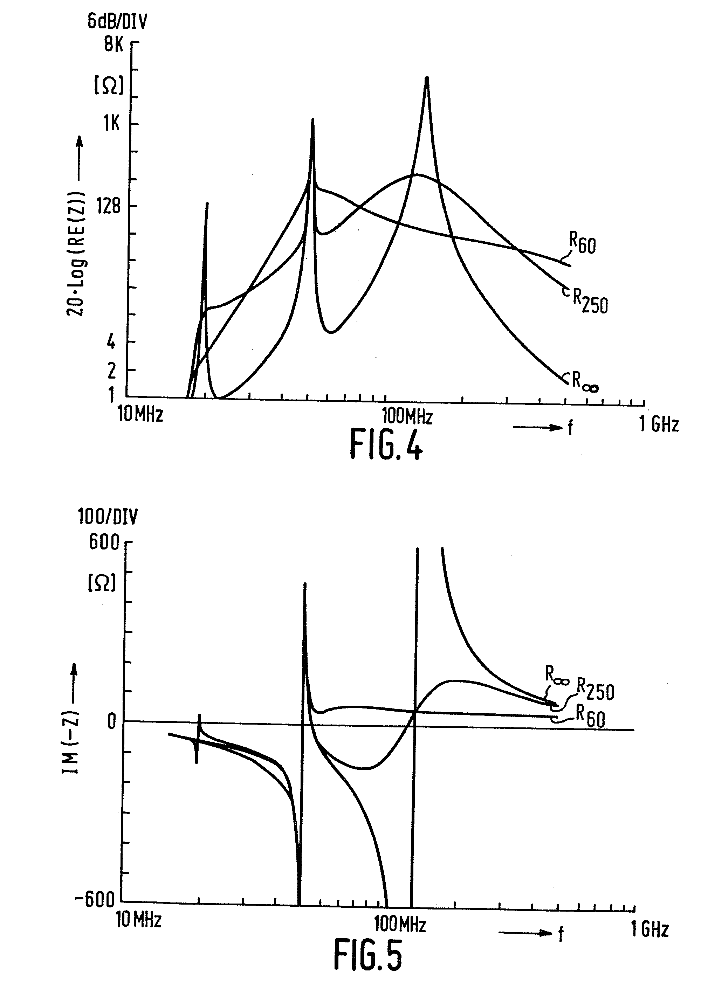

The influence of the resistance $R_p$ on the impedance of the resonant network Z is illustrated in Figures 4 and 5 by curves R $\infty$ ($R_p = \infty$ ), $R_{250}$ ($R_p = 250\,\Omega$ ) and $R_{60}$ ($R_p = 60\,\Omega$ ). Figure 4 shows the frequency-dependent variation of the real part of the impedance of the resonant network Z and Figure 5 shows the corresponding variation of the imaginary part of that impedance. This is based on a crystal resonator Q having a desired $3^{rd}$ order crystal frequency $3f_o$ of 50 MHz, a crystal capacitance of approximately 5 pF and series resonance resistances $R_1$ and $R_3$ of $7\,\Omega$ and $10\,\Omega$ , respectively, a capacitance $C_1$ of 25 pF and an inductance L of 400 nH. Figure 4 shows that when the resonant frequency of the parallel LC-network $LC_1$ is equal to the desired third order crystal frequency $3f_o$ (50 MHz), a decreasing resistance $R_p$ hardly affects the impedance of the resonant network Z at this desired crystal frequency $3f_o$, and that this decreasing resistance reduces said impedance to a very high extent at the un-

wanted crystal frequency $f_o$ and particularly so at the parasitic resonant frequency $f_{par}$ $(3\sqrt{5}f_o)$. Figure 5 shows that this resistance $R_p$ prevents, when it has a low value (for example $R_p = 60\,\Omega$ ), zero-crossings from occurring in the imaginary part of the impedance of the resonant network Z at the unwanted resonant frequencies $(f_o, f_{par})$. The said impedance is then only real at the desired crystal frequency $3f_o$.

In the example given an effective suppression of oscillation at the unwanted resonant frequencies $f_{par}$, $f_o$, $5f_o$..... is already accomplished at a value of $R_p$ of approximately $250\,\Omega$. It will be obvious that $R_p$ cannot be chosen to have an unlimited low value, as then the crystal resonator Q will be damped too highly. In order to keep the influence of the resistance $R_p$ on the impedance of the resonant network Z low at the desired crystal frequency $3f_o$, this resistance $R_p$ must exceed the value of the series resonance resistance $R_3$ (see Figure 3B) by a sufficient amount to ensure that $R_p$ hardly affects the value of the parallel arrangement of $R_p$ and $R_3$.

It will be obvious that the effective value of the resistance $R_p$ is co-determined by the capacitance ratio between $C_1$ and $C_2$ and it will not be difficult for a person skilled in the art to determine an effective value for $R_p$ also for component values and crystal frequencies $(5f_o, 7f_o.....)$, other than those of the above example, oscillation being prevented at the parasitic resonant frequency $f_{par}$ and only occurring at the desired higher order crystal frequency stabilized by the crystal resonator Q.

In the embodiment shown, the inductance L forms a direct current path which simplifies the direct current setting of the amplifier arrangement A. The positions of the components $C_1$ and L of the parallel LC-network $LC_1$ in the resonant network Z are, however, in principle not important for the invention and these positions can be mutually interchanged if the direct current supply to the amplifier arrangement A is suitably adapted.

0127238

In addition, it is possible to apply the invention to an oscillator circuit which is the dual of the oscillator circuit shown in Figure 1, this dual being shown in Figure 6. It comprises an amplifier arrangement A'which is connected to a resonant network Y via a terminal $t'$. The amplifier arrangement A' is known per se, for example from the German Patent Application No. 3,104,849 which has been laid open to public inspection. To understand how the invention is applied here it is sufficient to know that this amplifier arrangement A' operates as a current-controlled voltage source whose terminal $t'$ constitutes both the voltage output and the current input. The amplifier arrangement A' produces at the terminal $t'$ an output voltage which is controlled by the current through the resonant network Y. Arrangement A' must consequently be considered as a negative resistance -R which, for alternating current, is arranged in series with the resonant network Y. Arranged between the terminal $t'$ and a ground-reference level the resonant network Y comprises a series LC-network $L'C_1'$, which is arranged in series with the parallel arrangement of the crystal resonator Q and the resistor $R_p$.

In accordance with what has been described in the foregoing for the resonant network Z, a stable oscillation at a desired higher order crystal frequency ($3f_o$, $5f_o$ .....) is obtained by choosing the resonant frequncy of the series LC-network $L'C_1'$ to be equal to this desired higher order crystal frequency and by choosing the resistance $R_p$ such that the real part of the impedance of the resonant network Y between the terminal $t'$ and the ground-reference level at the parasitic resonant frequency, which is now determined by the values of the components $L',C_1'$ and $C_2$, is higher than the real impedance of said network at the said desired crystal frequency.

1.    An oscillator circuit comprising an amplifier arrangement connected to a reference level  an output as well as an input thereof being coupled _via_ a single signal-carrying terminal to a resonant network which is connected to the same reference level as the amplifier arrangement, the resonant network including a crystal resonator, characterized in that the resonant network comprises a LC-network coupled to the crystal resonator for selection of a higher order resonant frequency of the crystal resonator, and also a resistor which is arranged in parallel with the crystal oscillator for preventing oscillations at the parasitic resonant frequency produced by the LC-network and the case capacitance of the crystal resonator.

2.    An oscillator circuit as claimed in Claim 1, characterized in that the amplifier arrangement has a current output which is coupled to the terminal and the resonant network comprises two branches arranged in parallel between the terminal and the reference level, one branch comprising a series arrangement of one of the two components of the LC-network and the parallel arrangement of the crystal resonator and the said resistor and the other branch comprising the other component of the LC-network, the real part of the impedance of the resonant network between the terminal and the reference level at the parasitic resonant frequency being smaller than the real impedance of said network at the said higher order resonant frequency of the crystal resonator.

3.    An oscillator circuit as claimed in Claim 2, characterized in that in the said one branch the capacitance of the LC-network is arranged in series with the parallel arrangement of the crystal resonator and the said resistor and that the inductance of the LC-network is included in the said other branch.

4.      An oscillator circuit as claimed in Claim 1, characterized in that the amplifier arrangement has a voltage output which is coupled to the terminal and the LC-network is a series LC-network arranged between the terminal and the reference level in series with the parallel arrangement of the crystal resonator and the said resistor, the real part of the impedance of the resonant network between the terminal and the reference level at the parasitic resonant frequency being larger than the real impedance of said network at the said higher order resonant frequency of the crystal resonator.

0127238

1/2

FIG.1

FIG.2

FIG.3

FIG.6

0127238

FIG.4

FIG.5

## European Patent Office

## EUROPEAN SEARCH REPORT

**0127238**
Application number

EP 84 20 0741

### DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| Y | GB-A-2 082 000 (PHILIPS) <br> * Page 1, line 1 - page 2, line 62; figures 1,2 * | 1-3 | H 03 B 5/36 |
| Y | GB-A-2 069 788 (INSTYTUT TELE-I RADIOTECHNICZNY) <br> * Page 1, line 38 - page 2, line 15; figures 1,2 * | 1 | |
| Y,D | US-A-4 134 085 (DRISCOLL et al.) <br> * Column 5, line 5 - column 6, line 19; figure 5 * | 1 | |
| Y | DE-A-2 818 374 (SIEMENS) <br> * Page 7, line 24 - page 8, line 30; figure 1 * | 2,3 | |
| A,D | GB-A-2 092 852 (PHILIPS) <br> * Whole document * | 1 | TECHNICAL FIELDS SEARCHED (Int. Cl. ³) <br><br> H 03 B <br> H 03 C |

The present search report has been drawn up for all claims

| Place of search <br> THE HAGUE | Date of completion of the search <br> 22-08-1984 | Examiner <br> DHONDT I.E.E. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03. 82